# EUROPEAN PATENT SPECIFICATION

(11) **EP 4 202 975 B1**
(45) Date of publication and mention of the grant of the patent: **06.11.2024**
(21) Application number: 22215144.1
(22) Date of filing: 20.12.2022
(51) Int. Cl.: H01J 37/32, C23C 16/455

(54) **SUBSTRATE PROCESSING APPARATUS**
SUBSTRATVERARBEITUNGSVORRICHTUNG
APPAREIL DE TRAITEMENT DE SUBSTRAT

(30) Priority: 23.12.2021 KR 20210186320
(43) Date of publication of application: 28.06.2023
(73) Proprietor: Samsung Display Co., Ltd., Yongin-si, Gyeonggi-do 17113 (KR)
(72) Inventor: KIM, Junggon, Hwaseong-si (KR); JANG, Choelmin, Seoul (KR); HUH, Myungsoo, Suwon-si (KR)
(74) Representative: Marks & Clerk LLP

(56) References cited:
- EP-A2- 3 006 598
- KR-A- 20180 031 982
- US-A1- 2013 137 267
- US-A1- 2015 152 554
- US-A1- 2017 081 764

## Description

### BACKGROUND

### 1. FIELD

Embodiments relate generally to a substrate processing apparatus. More particularly, embodiments relate to a deposition apparatus used for manufacturing a display device.

### 2. DESCRIPTION OF THE RELATED ART

A flat panel display is being used as a display device that replaces a cathode ray tube display due to characteristics such as light weight and thinness. Representative examples of such flat panel display devices include a liquid crystal display device and an organic light emitting display device.

The display device may include a substrate and a plurality of thin films formed on the substrate. The thin films may be formed by a deposition method such as physical vapor deposition ("PVD"), chemical vapor deposition ("CVD"), plasma enhanced chemical vapor deposition ("PECVD"), or the like.

KR 2018 0031982 A relates to a device for depositing a thin film and a method for depositing a composite layer.

US 2013/137267 A1 relates to methods of etching a substrate using an atomic layer deposition apparatus.

US 2017/081764 A1 relates to a substrate processing apparatus.

EP 3006598 A2 relates to an apparatus and a method of manufacturing a display apparatus.

US 2015/152554 A1 relates to a substrate processing apparatus and a method of manufacturing a semiconductor device.

### SUMMARY

Embodiments provide a substrate processing apparatus capable of efficient deposition and cleaning.

A substrate processing apparatus according to embodiments of the present invention includes: a chamber providing a space for processing a substrate, a first nozzle unit disposed inside the chamber, a second nozzle unit disposed inside the chamber and adjacent to the first nozzle unit, a remote plasma generator disposed outside the chamber and which is configured to convert a cleaning gas into a plasma state, a common pipe disposed outside the chamber and connected to the remote plasma generator through which the cleaning gas in the plasma state is able to flow from the remote plasma generator, a first connection pipe connecting the common pipe and the first nozzle unit, and in which a first common valve is installed, a second connection pipe connecting the common pipe and the second nozzle unit, and in which a second common valve is installed, a source gas supply pipe connected to the first connection pipe in the outside of the chamber, which is configured to supply a source gas to the first connection pipe, where a first supply valve is installed in the source gas supply pipe, and a reaction gas supply pipe connected to the second connecting pipe in the outside of the chamber, and which is configured to supply a reaction gas to the second connection pipe, where a second supply valve is installed in the reaction gas supply pipe.

In an embodiment, the source gas supply pipe may be connected to the first connection pipe between the first common valve and the first nozzle unit, and the reaction gas supply pipe may be connected to the second connection pipe between the second common valve and the second nozzle unit.

In an embodiment, the first nozzle unit may be configured to discharge the source gas or the cleaning gas in the plasma state, and the second nozzle unit may be configured to discharge the reaction gas or the cleaning gas in the plasma state.

In an embodiment, the substrate processing apparatus may further include: a first exhaust pump connected to the chamber and which is configured to exhaust a gas inside the chamber, and a second exhaust pump connected to the common pipe and which is configured to exhaust a gas inside the common pipe.

In an embodiment, the substrate processing apparatus may further include a first exhaust pipe connecting the chamber and the first exhaust pump, and in which a first exhaust valve is installed, and a second exhaust pipe connecting the common pipe and the second exhaust pump, and in which a second exhaust valve is installed.

In an embodiment, each of the first nozzle unit and the second nozzle unit may include a plasma generator.

In an embodiment, each of the first nozzle unit and the second nozzle unit may be provided in plurality, and the plurality of first nozzles and the plurality of second nozzles may be alternately arranged in one direction.

A substrate processing apparatus according to embodiments of the present invention includes: a chamber providing a space for processing a substrate, a first nozzle unit disposed inside the chamber, a second nozzle unit disposed inside the chamber and adjacent to the first nozzle unit, a remote plasma generator disposed outside the chamber and which is configured to convert a reaction gas or a cleaning gas into a plasma state, a common pipe disposed outside the chamber and connected to the remote plasma generator through which the reaction gas in a plasma state or the cleaning gas in a plasma state is able to flow from the remote plasma generator, a first connection pipe connecting the common pipe and the first nozzle unit, and in which a first common valve is installed, a second connection pipe connecting the common pipe and the second nozzle unit, and in which a second common valve is installed, and a first source gas supply pipe connected to the first connection pipe in the outside of the chamber, and which is configured to supply a first source gas to the first connection pipe, where a first-first supply valve is installed in the first source gas supply pipe.

In an embodiment, the first source gas supply pipe may be connected to the first connection pipe between the first common valve and the first nozzle unit.

In an embodiment, the first nozzle unit may be configured to discharge the first source gas or the cleaning gas in the plasma state to the substrate, and the second nozzle unit may be configured to discharge the reaction gas in the plasma state or the cleaning gas in the plasma state to the substrate.

In an embodiment, the substrate processing apparatus may further include a reaction gas supply pipe connected to the remote plasma generator, and which is configured to supply the reaction gas to the remote plasma generator, where a second supply valve is installed in the reaction gas supply pipe, and a cleaning gas supply pipe connected to the remote plasma generator, and which is configured to supply the cleaning gas to the remote plasma generator, where a third supply valve is installed in the cleaning gas supply pipe.

In an embodiment, the first nozzle unit may include a plasma generator.

In an embodiment, the substrate processing apparatus may further include a first exhaust pump connected to the chamber and which is configured to exhaust a gas inside the chamber, a second exhaust pump connected to the common pipe and which is configured to exhaust a gas inside the common pipe, a first exhaust pipe connecting the chamber and the first exhaust pump, and in which a first exhaust valve is installed, and a second exhaust pipe connecting the common pipe and the second exhaust pump, and in which a second exhaust valve is installed.

In an embodiment, the substrate processing apparatus may further include a third nozzle unit disposed inside the chamber, a third connection pipe connecting the common pipe and the third nozzle unit, and in which a third common valve is installed, and a second source gas supply pipe connected to the third connection pipe in the outside of the chamber, and which is configured to supply a second source gas different from the first source gas to the third connection pipe, where a first-second supply valve is installed in the second source gas supply pipe.

At least some of the above and other features of the invention are set out in the claims.

A substrate processing apparatus according to embodiments of the present invention include a remote plasma generator and a common pipe connected to the remote plasma generator. The common pipe is connected to plurality of nozzle units through a plurality of connection pipes. According to the opening and closing of common valves installed in the connection pipes, a cleaning gas converted into a plasma state in the remote plasma generator may be introduced into the nozzle units through the common pipe and the connection pipes and may be discharged into the chamber by the nozzle units. Accordingly, cleaning efficiency inside the chamber may be effectively improved.

In addition, the substrate processing apparatus may include a first exhaust pump connected to the chamber and a second exhaust pump connected to the common pipe. Accordingly, the gas remaining in the common pipe and the connection pipes as well as the inside of the chamber may be sufficiently exhausted. Accordingly, deterioration of the deposition efficiency of a thin film by the residual gas may be effectively prevented or reduced.

### BRIEF DESCRIPTION OF THE DRAWINGS

Illustrative, non-limiting embodiments will be more clearly understood from the following detailed description in conjunction with the accompanying drawings.
FIG. 1 is a diagram schematically illustrating a substrate processing apparatus according to an embodiment.
FIG. 2 is a perspective view of the substrate processing apparatus of FIG. 1.
FIG. 3 is a cross-sectional view of the substrate processing apparatus of FIG. 1.
FIGS. 4, 5, and 6 are cross-sectional views for explaining an operation of the substrate processing apparatus of FIG. 3.
FIG. 7 is a diagram schematically illustrating a substrate processing apparatus according to another embodiment.
FIGS. 8 and 9 are cross-sectional views for explaining an operation of the substrate processing apparatus of FIG. 7.
FIG. 10 is a diagram schematically illustrating a substrate processing apparatus according to still another embodiment.
FIGS. 11 and 12 are cross-sectional views for explaining an operation of the substrate processing apparatus of FIG. 10.

### DETAILED DESCRIPTION

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof. Hereinafter, embodiments of the present disclosure will be explained in detail with reference to the accompanying drawings. The same reference numerals are used for the same components in the drawings, and redundant descriptions of the same components will be omitted.

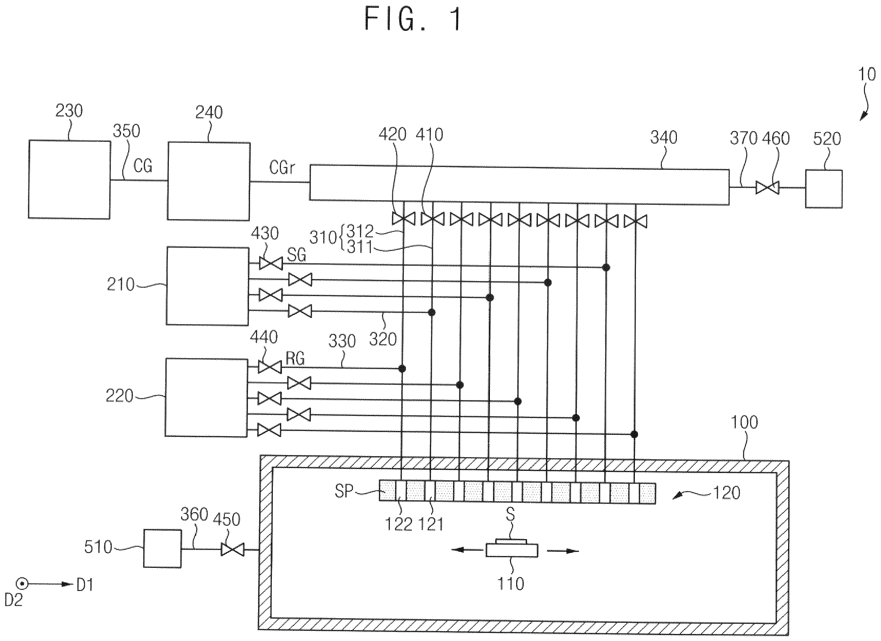

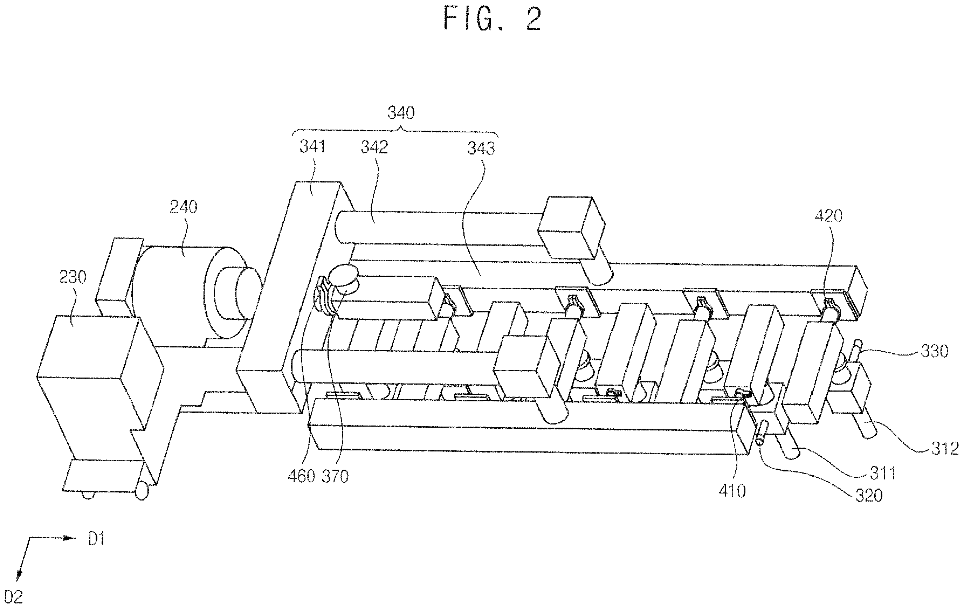

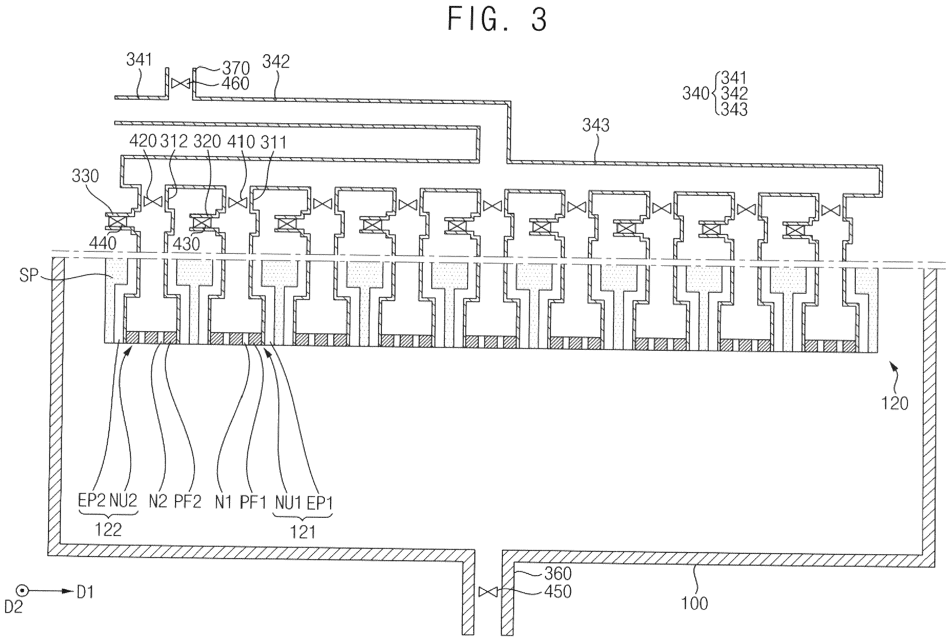

FIG. 1 is a diagram schematically illustrating a substrate processing apparatus according to an embodiment. FIG. 2 is a perspective view of the substrate processing apparatus of FIG. 1. FIG. 3 is a cross-sectional view of the substrate processing apparatus of FIG. 1.

Referring to FIGS. 1, 2, and 3, the substrate processing apparatus 10 according to an embodiment of the present invention may include a chamber 100, a substrate support portion 110, a nozzle group 120, a source gas supply portion 210, a reaction gas supply portion 220, a cleaning gas supply portion 230, a remote plasma generator 240, connection pipes 310, source gas supply pipes 320, reaction gas supply pipes 330, common pipe 340, a first exhaust pump 510 and a second exhaust pump 520.

The chamber 100 provides a space in which a processing process for the substrate S is performed. In an embodiment, the chamber 100 may be a chamber for chemical vapor deposition (CVD) or plasma enhanced chemical vapor deposition (PECVD). In another embodiment, the chamber 100 may be a chamber for atomic layer deposition ("ALD") or plasma enhanced atomic layer deposition ("PEALD"), or capable of selectively performing the chemical vapor deposition and the atomic layer deposition.

The substrate support portion 110 may be disposed inside the chamber 100 and may support the substrate S. In an embodiment, the substrate support portion 110 may reciprocate in a first direction D1 and in a direction opposite to the first direction D1 in a state in which the substrate S is supported.

The nozzle group 120 is disposed inside the chamber 100. The nozzle group 120 may discharge or exhaust a gas for forming a thin film on the substrate S. In addition, the nozzle group 120 may discharge or exhaust a gas for cleaning the inside of the chamber 100. In an embodiment, the nozzle group 120 may be fixed in the chamber 100. In another embodiment, the nozzle group 120 may reciprocate in the first direction D1 and in a direction opposite to the first direction D1.

The nozzle group 120 may include a plurality of nozzle units and a support portion SP supporting the nozzle units. The nozzle units may be arranged side by side in the first direction D1. The nozzle units may be fixed to the support portion SP.

In an embodiment, the nozzle group 120 includes first nozzle portions 121 and second nozzle portions 122. For example, the first nozzle portions 121 and the second nozzle portions 122 may be alternately arranged in the first direction D1. Although FIG. 1 shows that the nozzle group 120 includes four first nozzle portions 121 and five second nozzle portions 122, this is an example and the present invention is not limited thereto. In another embodiment, for example, the nozzle group 120 may include one to three or five or more first nozzle portions 121 and one to four or six or more second nozzle portions 122.

The first nozzle portions 121 and the second nozzle portions 122 are connected to the connection pipes 310, respectively. For example, the first nozzle portions 121 may be connected one-to-one with first connection pipes 311, and the second nozzle portions 122 may be connected one-to-one with second connection pipes 312.

As shown in FIG. 3, each of the first nozzle portions 121 may include a first nozzle unit NU1 and a first exhaust portion EP1. The first nozzle unit NU1 may include a first nozzle N1 and a first plasma generator PF 1.

In an embodiment, the first nozzle N1 may be provided in a plurality. The plurality of first nozzles N1 may be connected to the first connection pipe 311. The first nozzles N1 may discharge a source gas SG or a cleaning gas CG introduced through the first connection pipe 311. Although the first nozzle unit NU1 is illustrated as including two first nozzles N1 in FIG. 3, this is an example and the present invention is not limited thereto. In another embodiment, for example, the first nozzle unit NU1 may include three or more first nozzles N1.

The first plasma generator PF1 may convert the source gas SG discharged from the first nozzles N1 into a plasma state. That is, the first plasma generator PF1 may convert the source gas SG discharged from the first nozzles N1 into a radical form. The first plasma generator PF1 may be disposed to correspond to the first nozzle unit NU1 and may include an electrode.

The first exhaust potion EP1 may be disposed outside the first nozzle unit NU1. The first exhaust portion EP1 may exhaust gas. For example, the first exhaust portion EP1 may be disposed to surround the first nozzle unit NU1.

Each of the second nozzle portions 122 may include a second nozzle unit NU2 and a second exhaust portion EP2. The second nozzle unit NU2 may include a second nozzle N2 and a second plasma generator PF2.

In an embodiment, the second nozzle N2 may be provided in a plurality. The plurality of second nozzles N2 may be connected to the second connection pipe 312. The second nozzles N2 may discharge a reaction gas RG or the cleaning gas CG introduced through the second connection pipe 312.

The second plasma generator PF2 may convert the reaction gas RG discharged from the second nozzles N2 into a plasma state. That is, the second plasma generator PF2 may convert the reaction gas RG discharged from the second nozzles N2 into a radical form. The second plasma generator PF2 may be disposed to correspond to the second nozzle unit NU2 and may include an electrode.

The second exhaust portion EP2 may be disposed outside the second nozzle unit NU2. The second exhaust portion EP2 may exhaust a gas. For example, the second exhaust portion EP2 may be disposed to surround the second nozzle unit NU2.

In an embodiment, the first nozzle units NU1 and the second nozzle units NU2 may be alternately arranged in the first direction D 1. That is, each of the second nozzle units NU2 may be adjacent to one or two of the first nozzle units NU1. For example, the first nozzle units NU1 may be connected one-to-one to the first connection pipes 311, and the second nozzle units NU2 may be connected to one-to-one to the second connection pipes 312.

The first connection pipes 311 connect the first nozzle units NU1 and the common pipe 340, respectively. A first common valve 410 that can be opened and closed is installed in each of the first connection pipes 311. For example, the first common valve 410 may be installed adjacent to the common pipe 340.

The second connection pipes 312 connect the second nozzle units NU2 and the common pipe 340, respectively. A second common valve 420 that can be opened and closed is installed in each of the second connection pipes 312. For example, the second common valve 420 may be installed adjacent to the common pipe 340.

The source gas supply portion 210 may be disposed outside the chamber 100. The source gas supply portion 210 may be connected to the first connection pipes 311 through the source gas supply pipes 320. The source gas supply portion 210 may supply the source gas SG to the first nozzle units NU1 through the source gas supply pipes 320 and the first connection pipes 311. For example, the source gas SG may include SiH₄, SiF₄, SiH₂Cl₂, Si₂H₆, or the like, but these are examples, and the present invention is not limited thereto.

The source gas supply pipes 320 may connect the source gas supply portion 210 and the first connection pipes 311, respectively. The source gas supply pipes 320 are connected to the first connection pipes 311, respectively, in the outside of the chamber 100. A first supply valve 430 that can be opened and closed is installed in each of the source gas supply pipes 320.

In an embodiment, each of the source gas supply pipes 320 may be connected to the first connection pipe 311 between the first common valve 410 and the first nozzle unit NU1. For example, the first common valve 410 may be installed to a front end of the first connection pipe 311 so as to be adjacent to the common pipe 340. The source gas supply pipe 320 may be connected to a rear end of the first connection pipe 311 so as to be adjacent to the first nozzle unit NU1.

The reaction gas supply portion 220 may be disposed outside the chamber 100. The reaction gas supply portion 220 may be connected to the second connection pipes 312 through the reaction gas supply pipes 330. The reaction gas supply portion 220 may supply the reaction gas RG to the second nozzle units NU2 through the reaction gas supply pipes 330 and the second connection pipes 312. For example, the reaction gas RG may include N₂, O₂, H₂, NH₃, or the like, but these are examples and the present invention is not limited thereto.

The reaction gas supply pipes 330 may connect the reaction gas supply portion 220 and the second connection pipes 312, respectively. The reaction gas supply pipes 330 are respectively connected to the second connection pipes 312 outside the chamber 100. The second supply valve 440 that can be opened and closed is installed in each of the reaction gas supply pipes 330.

In an embodiment, each of the reaction gas supply pipes 330 may be connected to the second connection pipe 312 between the second common valve 420 and the second nozzle unit NU2. For example, the second common valve 420 may be installed at a front end of the second connection pipe 312 so as to be adjacent to the common pipe 340. The reaction gas supply pipe 330 may be connected to a rear end of the second connection pipe 312 so as to be adjacent to the second nozzle unit NU2.

The cleaning gas supply portion 230 may be disposed outside the chamber 100. The cleaning gas supply portion 230 may supply the cleaning gas CG to the remote plasma generator 240 through the cleaning gas supply pipe 350. A third supply valve (not shown) that can be opened and closed may be installed in the cleaning gas supply pipe 350. For example, the cleaning gas CG may include NF₃, CF₄, C₂F₆, or the like, but these are examples and the present invention is not limited thereto.

The remote plasma generator 240 is disposed outside the chamber 100. The remote plasma generator 240 converts the cleaning gas CG introduced from the cleaning gas supply portion 230 into a plasma state. That is, the remote plasma generator 240 converts the cleaning gas CG introduced from the cleaning gas supply portion 230 into a radical form. For example, when the cleaning gas CG is NF₃, the cleaning gas CG may be ionized into radicals such as NF₂, NF, F, and N by the remote plasma generator 240 to be in a plasma state.

The remote plasma generator 240 supplies the cleaning gas CGr in a plasma state (i.e., ionized cleaning gas CGr) to the first nozzle units NU1 and the second nozzle units NU2 through the common pipe 340 and the connection pipes 310. A radical of the cleaning gas CGr in the plasma state discharged from the first nozzle units NU1 and the second nozzle units NU2 reacts with by-product inside the chamber 100 to convert the by-product into a gaseous state, and as the gaseous by-product is exhausted, cleaning of the inside of the chamber 100 may proceed. That is, unlike the source gas SG converted into a plasma state by the first plasma generator PF1 and the reaction gas RG converted into a plasma state by the second plasma generator PF2, the cleaning gas CG may be supplied to the first nozzle units NU1 and the second nozzle units NU2 as the cleaning gas CGr in a plasma state to be discharged. Accordingly, cleaning efficiency inside the chamber 100 may be improved.

The common pipe 340 is disposed outside the chamber 100. The common pipe 340 is connected to the remote plasma generator 240 and the connection pipes 310. The common pipe 340 transfers the cleaning gas CGr in a plasma state introduced from the remote plasma generator 240 to the first nozzle units NU1 and the second nozzle units NU2 through the connection pipes 310.

In an embodiment, the remote plasma generator 240 and the common pipe 340 may be disposed adjacent to the chamber 100. In addition, the common pipe 340 may have a relatively large diameter. For example, the common pipe 340 may have a larger diameter than the source gas supply pipes 320 or the reaction gas supply pipes 330. Accordingly, while the cleaning gas CGr in a plasma state moves to the first nozzle units NU1 and the second nozzle units NU2 through the common pipe 340 and the connection pipes 310, it may be possible to prevent or reduce the plasma state being lost and converted to a stable state. Accordingly, cleaning efficiency inside the chamber 100 may be improved.

In an embodiment, as shown in FIG. 2, the common pipe 340 may include a first pipe 341, a second pipe 342, and a third pipe 343.

The first pipe 341 may be connected to the remote plasma generator 240. For example, the first pipe 341 may extend in a second direction D2 crossing the first direction D1.

The second pipe 342 may be connected to the first pipe 341. In an embodiment, the two second pipes 342 may be respectively connected to both ends of the first pipe 341. The second pipes 342 may extend in the first direction D1.

The third pipe 343 may be connected to the second pipe 342. In an embodiment, the two third pipes 343 may be connected to the two second pipes 342, respectively. The third pipes 343 may extend in the first direction D1. The first connection pipes 311 and the second connection pipes 312 alternately arranged in the first direction D1 may be connected to the third pipes 343. For example, as shown in FIG. 2, the first connection pipes 311 and the first common valves 410 may be connected to any one of the third pipes 343, and the second connection pipes 312 and the second common valves 420 may be connected to the other one of the third pipes 343.

For example, the second pipes 342 may be connected to a central portion of the third pipes 343. Accordingly, the cleaning gas CGr in a plasma state introduced from the remote plasma generator 240 may be evenly transferred to the first connection pipe 311 and the second connection pipe 312.

However, a shape of the common pipe 340 shown in FIG. 2 is an example, and the present invention is not limited thereto. In another embodiment, for example, the common pipe 340 may be configured as a single pipe connected to the remote plasma generator 240 and extending in the first direction D1.

The first exhaust pump 510 may be connected to the chamber 100 through a first exhaust pipe 360. A first exhaust valve 450 that can be opened and closed may be installed in the first exhaust pipe 360. The first exhaust pump 510 may exhaust a gas inside the chamber 100.

The second exhaust pump 520 may be connected to the common pipe 340 through a second exhaust pipe 370. A second exhaust valve 460 that can be opened and closed may be installed in the second exhaust pipe 370. The second exhaust pump 520 may exhaust a gas inside the common pipe 340. In a state in which the first common valve 410 and the second common valve 420 are opened, the second exhaust pump 520 may further exhaust a gas inside the connection pipes 310.

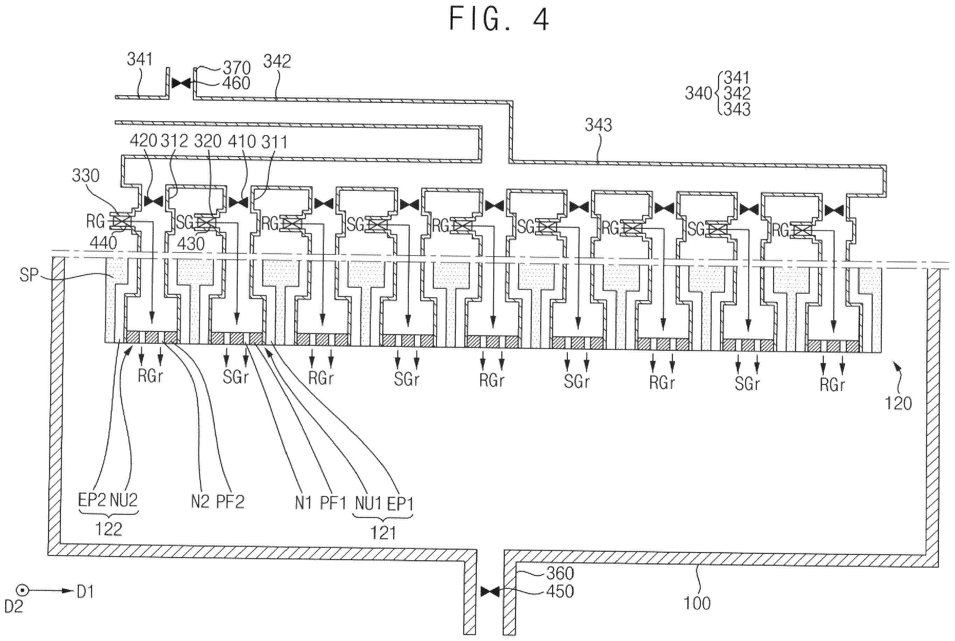

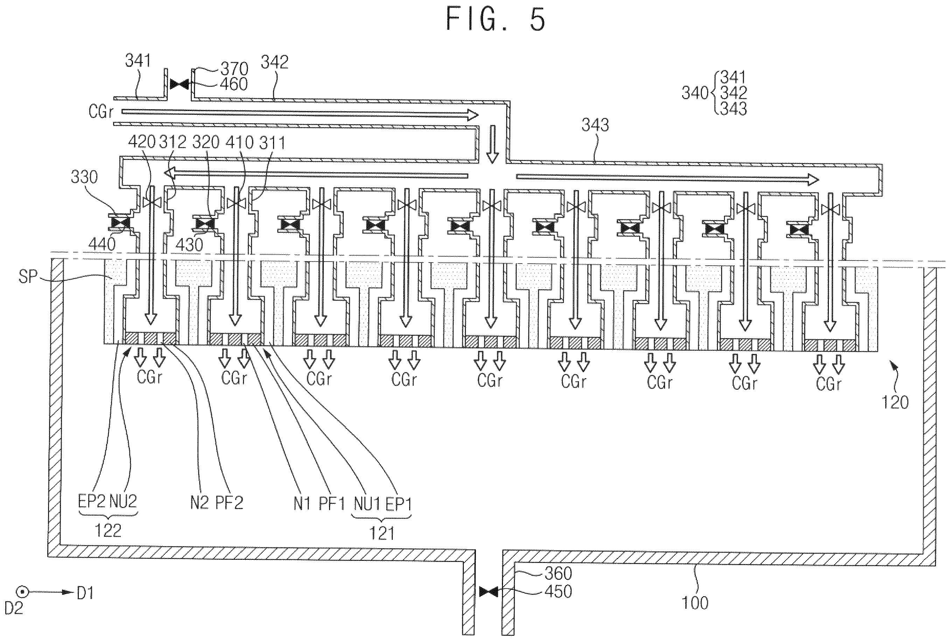

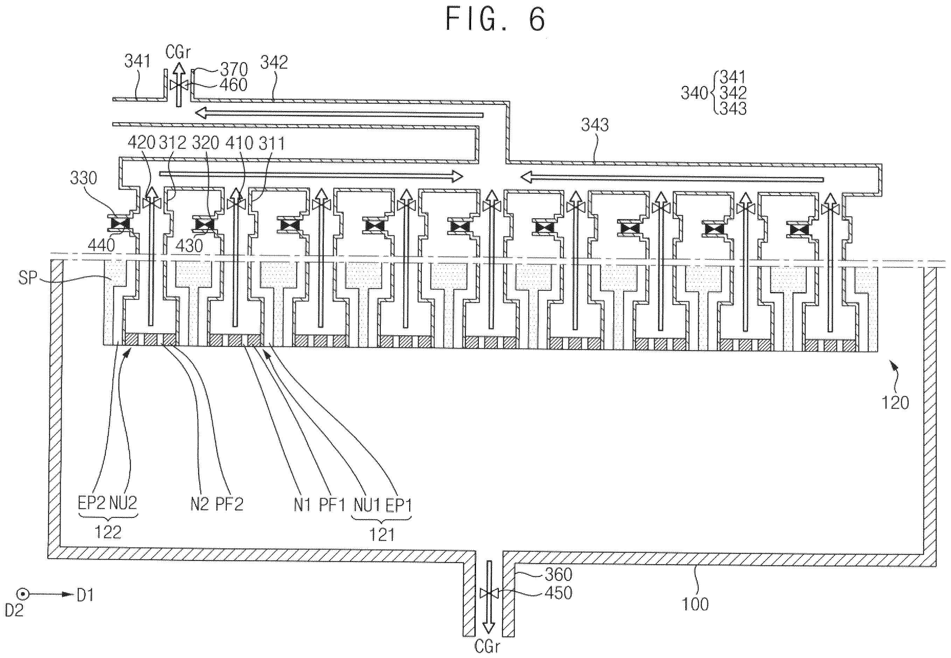

FIGS. 4, 5, and 6 are cross-sectional views for explaining an operation of the substrate processing apparatus of FIG. 3. For example, FIG. 4 shows a thin film deposition process on the substrate S, FIG. 5 shows a cleaning process inside the chamber 100, and FIG. 6 shows an exhaust process after the cleaning.

Referring to FIGS. 1 and 4, the first supply valves 430 installed in the source gas supply pipes 320 may be opened. Accordingly, the source gas SG may be introduced from the source gas supply portion 210 into the first nozzle units NU1 through the source gas supply pipes 320 and the first connection pipes 311. The first nozzle units NU1 may discharge the source gas SG. For example, the source gas SG discharged from the first nozzles N1 may be converted into a plasma state by the first plasma generator PF1. In this case, the first common valves 410 installed in the first connection pipes 311 may be in a closed state. Accordingly, the cleaning gas CGr in a plasma state from the common pipe 340 may not flow into the first connection pipes 311.

In addition, the second supply valves 440 installed in the reaction gas supply pipes 330 may be opened. Accordingly, the reaction gas RG may be introduced from the reaction gas supply portion 220 into the second nozzle units NU2 through the reaction gas supply pipes 330 and the second connection pipes 312. The second nozzle units NU2 may discharge the reaction gas RG. For example, the reaction gas RG discharged from the second nozzles N2 may be converted into a plasma state by the second plasma generator PF2. In this case, the second common valves 420 installed in the second connection pipes 312 may be in a closed state. Accordingly, the cleaning gas CGr in a plasma state from the common pipe 340 may not flow into the second connection pipes 312.

A thin film may be formed on the substrate S by reacting the source gas SGr discharged from the first nozzles N1 and converted into a plasma state, and the reaction gas RGr discharged from the second nozzles N2 and converted into a plasma state. For example, as the first nozzle portions 121 and the second nozzle portions 122 are alternately arranged in the first direction D1, and the substrate support portion 110 moves in the first direction D1, a plurality of thin films may be sequentially formed on the substrate S.

In an embodiment, for example, when the source gas SG includes SiH₄ and the reaction gas RG includes N₂, a silicon nitride film may be formed on the substrate S. As another example, when the source gas SG includes SiH₄ and the reaction gas RG includes O₂, a silicon oxide film may be formed on the substrate S. As still another example, when the source gas SG includes hexamethyldisiloxane ("HMDSO") and the reaction gas RG includes N₂ or Hz, after an organic film is formed on the substrate S, the organic film may be cured. However, this is an example, and the present invention is not limited thereto.

Referring to FIGS. 1 and 5, in order to clean the inside of the chamber 100 after the thin film is deposited on the substrate S, the first supply valves 430 installed in the source gas supply pipes 320 may be closed. Accordingly, the source gas SG from the source gas supply portion 210 may not flow into the first connection pipes 311. In addition, the first common valves 410 installed in the first connection pipes 311 may be opened. Accordingly, the cleaning gas CGr in a plasma state may be introduced from the remote plasma generator 240 into the first nozzle units NU1 through the common pipe 340 and the first connection pipes 311. The first nozzles N1 may discharge the cleaning gas CGr in a plasma state.

In addition, the second supply valves 440 installed in the reaction gas supply pipes 330 may be closed. Accordingly, the reaction gas RG from the reaction gas supply portion 220 may not flow into the second connection pipes 312. In addition, the second common valves 420 installed in the second connection pipes 312 may be opened. Accordingly, the cleaning gas CGr in a plasma state may be introduced into the second nozzle units NU2 from the remote plasma generator 240 through the common pipe 340 and the second connection pipes 312. The second nozzles N2 may discharge the cleaning gas CGr in a plasma state.

A radical of the cleaning gas CGr in a plasma state discharged from the first nozzles N1 and the second nozzles N2 react with by-product inside the chamber 100 to convert the by-product into a gaseous state, and as the gaseous by-product is exhausted, the inside of the chamber 100 may be cleaned.

Referring to FIGS. 1 and 6, in order to exhaust gas (e.g., the cleaning gas CG, or the like) and the by-product remaining in the chamber 100 after the inside of the chamber 100 is cleaned, the first exhaust valve 450 installed in the first exhaust pipe 360 may be opened. Accordingly, the first exhaust pump 510 connected to the chamber 100 through the first exhaust pipe 360 may exhaust the gas and the by-product remaining in the chamber 100

In addition, in order to exhaust the gas (e.g., the cleaning gas CG, or the like) remaining in the common pipe 340 and the connection pipes 310, the second exhaust valve 460 installed in the second exhaust pipe 370 may be opened. In this case, the first common valves 410 installed in the first connection pipes 311 and the second common valves 420 installed in the second connection pipes 312 may be in an open state. Accordingly, the second exhaust pump 520 connected to the common pipe 340 through the second exhaust pipe 370 may effectively exhaust the gas remaining in the common pipe 340 and the connection pipes 310. Accordingly, it may be possible to prevent or reduce the effect of the cleaning gas CG remaining in the connection pipes 310 on a subsequent deposition process. Accordingly, the deposition efficiency of the thin film may be improved.

In an embodiment, the first exhaust valve 450 and the second exhaust valve 460 may be sequentially opened and closed. For example, in a state in which the second exhaust valve 460 is closed, the first exhaust valve 450 may be opened first. After the gas and the by-product remaining in the chamber 100 are sufficiently exhausted by the first exhaust pump 510, the first exhaust valve 450 may be closed and the second exhaust valve 460 may be opened. Accordingly, the gas remaining in the common pipe 340 and the connection pipes 310 by the second exhaust pump 520 may be effectively exhausted.

In another embodiment, the first exhaust valve 450 and the second exhaust valve 460 may simultaneously open and close.

After the chamber 100 and the common pipe 340 are sufficiently exhausted by the first exhaust pump 510 and the second exhaust pump 520, the first exhaust valve 450 and the second exhaust valve 460 may be closed. Subsequently, as the first common valves 410 and the second common valves 420 are closed, and the first supply valves 430 and the second supply valves 440 are opened, the thin film deposition on the substrate S of FIG. 4 may be repeated.

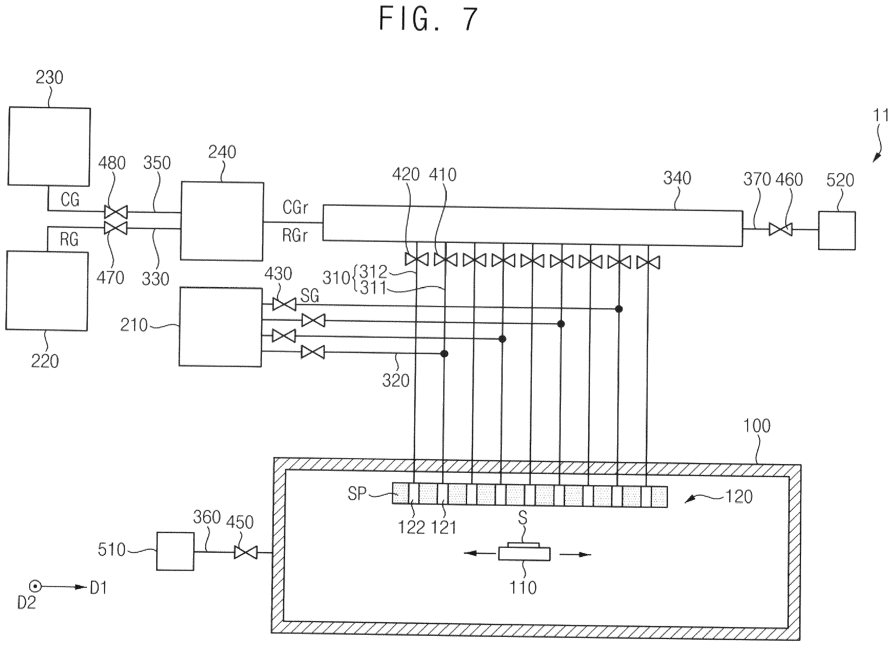

FIG. 7 is a diagram schematically illustrating a substrate processing apparatus according to another embodiment.

Hereinafter, the substrate processing apparatus 11 according to another embodiment will be described with a focus on the differences from the substrate processing apparatus 10 according to the embodiment described with reference to FIGS. 1 to 3, and the repeated description will be omitted or simplified.

Referring to FIG. 7, a chamber 100 provides a space in which a processing process for a substrate S is performed. A substrate support portion 110 may be disposed inside the chamber 100 and may support the substrate S. A nozzle group 120 is disposed inside the chamber 100. The nozzle group 120 may include first nozzle portions 121 and second nozzle portions 122 alternately arranged in the first direction D1.

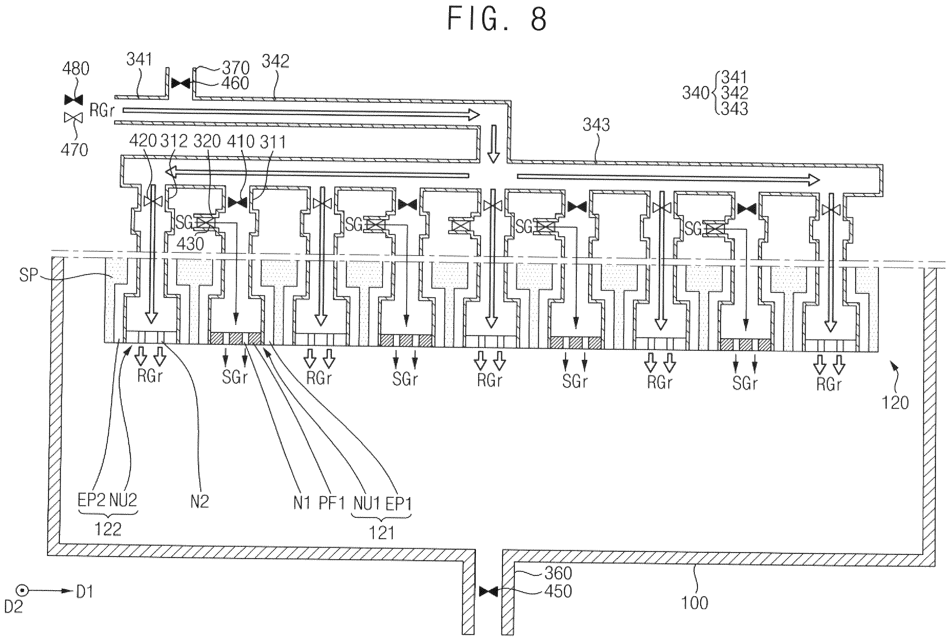

The first nozzle portions 121 and the second nozzle portions 122 are connected to connection pipes 310, respectively. As shown in FIG. 8, each of the first nozzle portions 121 may include a first nozzle unit NU1 and a first exhaust portion EP1. In an embodiment, the first nozzle unit NU1 may include a first nozzle N1 and a first plasma generator PF1.

Each of the second nozzle portions 122 may include a second nozzle unit NU2 and a second exhaust portion EP2. In an embodiment, the second nozzle unit NU2 may include the second nozzle N2 and may not include a separate plasma generator.

The first connection pipes 311 connect the first nozzle units NU1 and a common pipe 340, respectively. A first common valve 410 that can be opened and closed is installed in each of the first connection pipes 311. For example, the first common valve 410 may be installed adjacent to the common pipe 340.

The second connection pipes 312 connect the second nozzle units NU2 and the common pipe 340, respectively. A second common valve 420 that can be opened and closed is installed in each of the second connection pipes 312. For example, the second common valve 420 may be installed adjacent to the common pipe 340. In an embodiment, the second common valve 420 may be omitted.

A source gas supply portion 210 may be disposed outside the chamber 100. The source gas supply portion 210 may be connected to the first connection pipes 311 through source gas supply pipes 320. The source gas supply portion 210 may supply the source gas SG to the first nozzle units NU1 through the source gas supply pipes 320 and the first connection pipes 311.

The source gas supply pipes 320 may connect the source gas supply portion 210 and the first connection pipes 311, respectively. The source gas supply pipes 320 are respectively connected to the first connection pipes 311 outside the chamber 100. A first supply valve 430 that can be opened and closed is installed in each of the source gas supply pipes 320. In an embodiment, each of the source gas supply pipes 320 may be connected to the first connection pipe 311 between the first common valve 410 and the first nozzle unit NU1.

A reaction gas supply portion 220 may be disposed outside the chamber 100. The reaction gas supply portion 220 may supply the reaction gas RG to a remote plasma generator 240 through the reaction gas supply pipe 330. A second supply valve 470 that can be opened and closed may be installed in the reaction gas supply pipe 330.

A cleaning gas supply portion 230 may be disposed outside the chamber 100. The cleaning gas supply portion 230 may supply the cleaning gas CG to the remote plasma generator 240 through cleaning gas supply pipe 350. A third supply valve 480 that can be opened and closed may be installed in the cleaning gas supply pipe 350.

The second supply valve 470 and the third supply valve 480 may not be simultaneously opened. That is, the reaction gas RG and the cleaning gas CG may not be simultaneously introduced into the remote plasma generator 240.

In an embodiment, for example, in a state in which the second supply valve 470 is opened and the third supply valve 480 is closed, the reaction gas RG may be introduced into the remote plasma generator 240. In a state in which the second supply valve 470 is closed and the third supply valve 480 is opened, the cleaning gas CG may be introduced into the remote plasma generator 240. In a state in which both the second supply valve 470 and the third supply valve 480 are closed, a gas may not flow into the remote plasma generator 240.

The remote plasma generator 240 is disposed outside the chamber 100. The remote plasma generator 240 converts the reaction gas RG introduced from the reaction gas supply portion 220 or the cleaning gas CG introduced from the cleaning gas supply portion 230 into a plasma state.

In the present embodiment, unlike the substrate processing apparatus 10 of FIG. 1, during the deposition process on the substrate S, the reaction gas RG may be introduced into the first nozzle units NU1 and the second nozzle unit NU2 as the reaction gas RGr in a plasma state to be discharged.

In an embodiment, for example, when the reaction gas RG is N₂, a relatively large power may be desirable to convert the reaction gas RG into a plasma state. At this time, as in the substrate processing apparatus 10 of FIG. 1, when the reaction gas RG discharged from the second nozzles N2 is converted into a plasma state using the second plasma generator PF2, plasma control may not be easy.

However, according to the present embodiment, the remote plasma generator 240 converts the reaction gas RG to a plasma state, and supplies the reaction gas RGr in the plasma state to the first nozzle units NU1 and the second nozzle units NU2. Accordingly, plasma control may be facilitated even in the reaction gas RG, which requires a relatively large power to change the plasma state. In addition, according to an embodiment, as shown in FIG. 8, the second nozzle units NU2 may not include a separate plasma generator. Accordingly, the nozzle group 120 may include a relatively large number of the first nozzle portions 121 and the second nozzle portions 122.

The common pipe 340 is disposed outside the chamber 100. The common pipe 340 is connected to the remote plasma generator 240 and the connection pipes 310. The common pipe 340 transfers the reaction gas RGr in a plasma state (i.e., ionized reaction gas RGr) to the second nozzle units NU2 through the second connection pipes 312 or may transfer the cleaning gas CGr in a plasma state to the first nozzle units NU1 and the second nozzle unit NU2 through the connection pipes 310.

In an embodiment, the remote plasma generator 240 and the common pipe 340 may be disposed adjacent to the chamber 100. In addition, the common pipe 340 may have a relatively large diameter. For example, the common pipe 340 may have a larger diameter than the source gas supply pipes 320 or the reaction gas supply pipes 330. Accordingly, it may be possible to prevent or reduce the plasma state of the reaction gas RGr being lost and converted to a stable state (e.g., a state that does not react with the source gas SG) while the reaction gas RGr in the plasma state moves to the second nozzle units NU2 through the common pipe 340 and the second connection pipes 312. In addition, it may be possible to prevent or reduce the plasma state of the cleaning gas CGr being lost and converted to a stable state (e.g., a state that does not react with the by-product) while the cleaning gas CGr in a plasma state moves to the first nozzle units NU1 and the second nozzle units NU2 through the common pipe 340 and the connection pipes 310.

A first exhaust pump 510 may be connected to the chamber 100 through a first exhaust pipe 360. The first exhaust pump 510 may exhaust a gas inside the chamber 100. A second exhaust pump 520 may be connected to the common pipe 340 through a second exhaust pipe 370. The second exhaust pump 520 may exhaust a gas inside the common pipe 340.

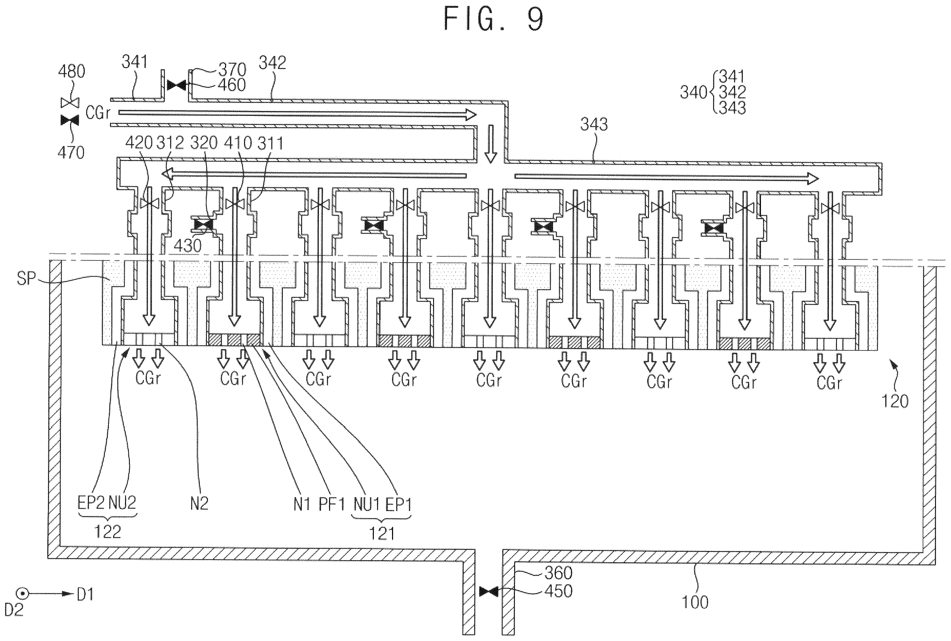

FIGS. 8 and 9 are cross-sectional views for explaining an operation of the substrate processing apparatus of FIG. 7. For example, FIG. 8 may correspond to FIG. 4, and FIG. 9 may correspond to FIG. 5. For example, FIG. 8 shows a thin film deposition process on the substrate S, and FIG. 9 shows a cleaning process inside the chamber 100.

Referring to FIGS. 7 and 8, the first supply valves 430 installed in the source gas supply pipes 320 may be opened. Accordingly, the source gas SG may be introduced from the source gas supply portion 210 into the first nozzle units NU1 through the source gas supply pipes 320 and the first connection pipes 311. The first nozzle units NU1 may discharge the source gas SG. For example, the source gas SG discharged from the first nozzles N1 may be converted into a plasma state by the first plasma generator PF 1. In this case, the first common valves 410 installed in the first connection pipes 311 may be in a closed state. Accordingly, the reaction gas RGr in a plasma state from the common pipe 340 may not flow into the first connection pipes 311.

In addition, the second supply valve 470 installed in the reaction gas supply pipe 330 may be opened, and the third supply valve 480 installed in the cleaning gas supply pipe 350 may be closed. Accordingly, the reaction gas RG may be introduced into the remote plasma generator 240 from the reaction gas supply portion 220.

In addition, the second common valves 420 installed in the second connection pipes 312 may be opened. Accordingly, the reaction gas RGr converted into a plasma state in the remote plasma generator 240 may be introduced into the second nozzle units NU2 through the common pipe 340 and the second connection pipes 312. The second nozzle units NU2 may discharge the reaction gas RGr in a plasma state.

A thin film may be formed on the substrate S by reacting the source gas SGr discharged from the first nozzles N1 and converted into a plasma state, and the reaction gas RGr in a plasma state discharged from the second nozzles N2. For example, as the first nozzle portions 121 and the second nozzle portions 122 are alternately arranged in the first direction D1 and the substrate support portion 110 reciprocates in the first direction D1, a plurality of thin films may be sequentially formed on the substrate S.

In an embodiment, for example, when the source gas SG includes SiH₄ and the reaction gas RG includes N₂, a silicon nitride film may be formed on the substrate S. As another example, when the source gas SG includes SiH₄ and the reaction gas RG includes O₂, a silicon oxide film may be formed on the substrate S. As still another example, when the source gas SG includes hexamethyldisiloxane (HMDSO) and the reaction gas RG includes N₂ or Hz, after an organic film is formed on the substrate S, the organic film may be cured immediately. However, this is an example, and the present invention is not limited thereto.

Referring to FIGS. 7 and 9, in order to clean the inside of the chamber 100 after the thin film is deposited on the substrate S, the first supply valves 430 installed in the source gas supply pipes 320 may be closed. Accordingly, the source gas SG from the source gas supply portion 210 may not flow into the first connection pipes 311.

In addition, the second supply valve 470 installed in the reaction gas supply pipe 330 may be closed, and the third supply valve 480 installed in the cleaning gas supply pipe 350 may be opened. Accordingly, the cleaning gas CG may be introduced into the remote plasma generator 240 from the cleaning gas supply portion 230.

In addition, the first common valves 410 installed in the first connection pipes 311 and the second common valves 420 installed in the second connection pipes 312 may be opened. Accordingly, the ionized cleaning gas CGr converted from the remote plasma generator 240 into a plasma state may be introduced to the first nozzle units NU1 and the second nozzle units NU2 through the common pipe 340 and the connection pipes 310. The first nozzles N1 and the second nozzles N2 may discharge the cleaning gas CGr in a plasma state.

A radical of the cleaning gas CGr in a plasma state discharged from the first nozzles N1 and the second nozzles N2 react with by-product inside the chamber 100 to convert the by-product into a gaseous state, and as the gaseous by-product is exhausted, cleaning of the inside of the chamber 100 may proceed.

An exhaust process after the cleaning of the inside of the chamber 100 is performed may be substantially the same as or similar to that described with reference to FIGS. 1 and 6.

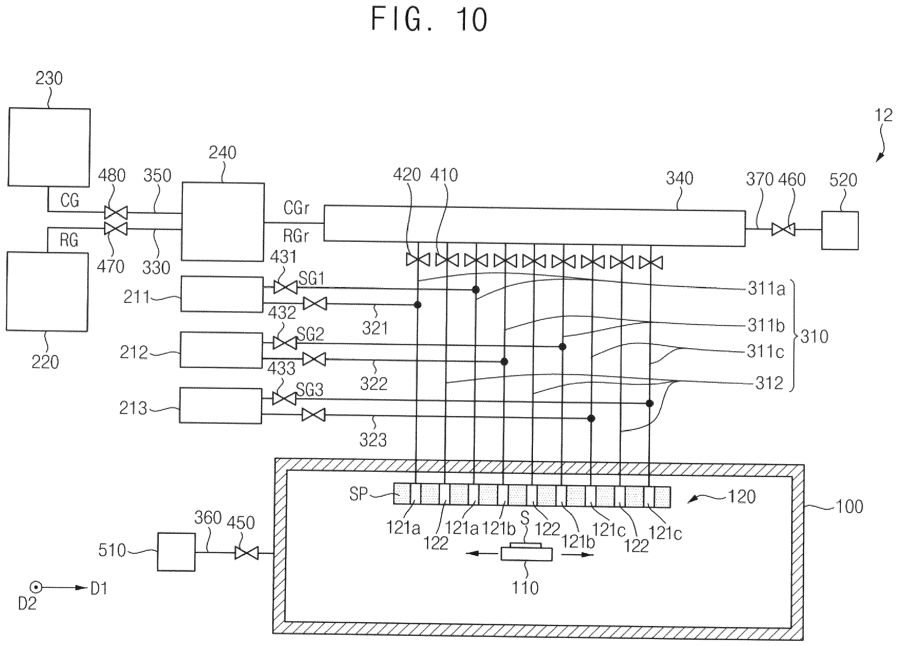

FIG. 10 is a diagram schematically illustrating a substrate processing apparatus according to still another embodiment.

Hereinafter, the substrate processing apparatus 12 according to another embodiment will be described with a focus on the differences from the substrate processing apparatus 10 according to an embodiment described with reference to FIGS. 1, 2, and 3 and the substrate processing apparatus 11 according to another embodiment described with reference to FIG. 7, and repeated descriptions will be omitted or simplified.

Referring to FIG. 10, a chamber 100 provides a space in which a processing process for a substrate S is performed. The substrate support portion 110 may be disposed inside the chamber 100 and may support the substrate S. A nozzle group 120 is disposed inside the chamber 100.

In an embodiment, the nozzle group 120 may include first-first nozzle portions 121a, first-second nozzle portions 121b, first-third nozzle portions 121c, and second nozzle portions 122. For example, the first-first nozzle portions 121a, the first-second nozzle portions 121b, and the first-third nozzle portions 121c may be nozzle portions each receiving first, second, and third source gases SG1, SG2, and SG3 from first, second, and third source gas supply portions 211, 212, and 213. The second nozzle portion 122 may be nozzle units receiving a reaction gas RG from a reaction gas supply portion 220. For example, the first to third source gases SG1, SG2, and SG3 may be different source gases respectively reacting with the reaction gas RG. However, this is an example and the present invention is not limited thereto. In another embodiment, for example, the first, second, and third source gases SG1, SG2, and SG3 may be different source gases respectively reacting with the reaction gas RG. However, this is an example and the present invention is not limited thereto.

In an embodiment, for example, as shown in FIG. 10, the first-first nozzle portion 121a, the second nozzle portion 122, the first-first nozzle portion 121a, the first-second nozzle portion 121b, the second nozzle portion 122, the first-second nozzle portion 121b, the first-third nozzle portion 121c, the second nozzle portion 122, and the first-third nozzle portion 121c may be arranged side by side in the first direction D1.

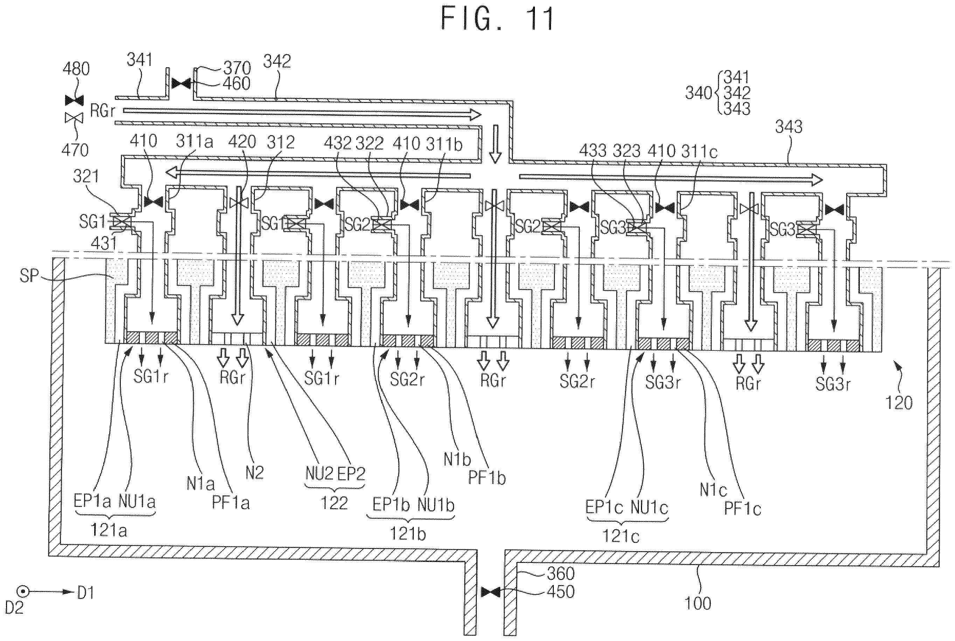

The first-first nozzle portions 121a may be respectively connected to first-first connection pipes 311a. As shown in FIG. 11, each of the first-first nozzle portions 121a may include a first-first nozzle unit NU1a and a first-first exhaust portion EP1a. In an embodiment, the first-first nozzle unit NU1a may include a first-first nozzle N1a and a first-first plasma generator PF1a.

The first-second nozzle portions 121b may be respectively connected to first-second connection pipes 311b. As shown in FIG. 11, each of the first-second nozzle portions 121b may include a first-second nozzle unit NUlb and a first-second exhaust portion EP1b. In an embodiment, the first-second nozzle unit NU1b may include a first-second nozzle N1b and a first-second plasma generator PF1b.

The first-third nozzle portions 121c may be respectively connected to first-third connection pipes 311c. As shown in FIG. 11, each of the first-third nozzle portions 121c may include a first-third nozzle unit NU1c and a first-third exhaust portion EPIc. In an embodiment, the first-third nozzle unit NU1c may include a first-third nozzle N1c and a first-third plasma generator PF1c.

The second nozzle portions 122 may be respectively connected to the second connection pipes 312. As shown in FIG. 11, each of second nozzle portions 122 may include a second nozzle unit NU2 and a second exhaust portion EP2. In an embodiment, the second nozzle unit NU2 may include a second nozzle N2 and may not include a separate plasma generator.

The first-first connection pipes 311a may connect the first-first nozzle units NU1a and a common pipe 340, respectively. The first-second connection pipes 311b may connect the first-second nozzle units NU1b and the common pipe 340, respectively. The first-third connection pipes 311c may connect the first-third nozzle units NU1c and the common pipe 340, respectively. A first common valve 410 that can be opened and closed may be installed in each of the first-first connection pipes 311a, the first-second connection pipes 311b, and the first-third connection pipes 311c. For example, the first common valve 410 may be installed adjacent to the common pipe 340.

The second connection pipes 312 may connect the second nozzle units NU2 and the common pipe 340, respectively. A second common valve 420 that can be opened and closed may be installed in each of the second connection pipes 312. For example, the second common valve 420 may be installed adjacent to the common pipe 340. In an embodiment, the second common valve 420 may be omitted.

The first source gas supply portion 211 may be disposed outside the chamber 100. The first source gas supply portion 211 may be connected to the first-first connection pipes 311a through first source gas supply pipes 321. The first source gas supply portion 211 may supply the first source gas SG1 to the first-first nozzle units NU1a through the first source gas supply pipes 321 and the first-first connection pipes 311a.

The second source gas supply portion 212 may be disposed outside the chamber 100. The second source gas supply portion 212 may be connected to the first-second connection pipes 311b through second source gas supply pipes 322. The second source gas supply portion 212 may supply the second source gas SG2 to the first-second nozzle units NUlb through the second source gas supply pipes 322 and the first-second connection pipes 311b.

The third source gas supply portion 213 may be disposed outside the chamber 100. The third source gas supply portion 213 may be connected to the first-third connection pipes 311c through third source gas supply pipes 323. The third source gas supply portion 213 may supply the third source gas SG3 to the first-third nozzle units NU1c through the third source gas supply pipes 323 and the first-third connection pipes 311c.

The first source gas supply pipes 321 may connect the first source gas supply portion 211 and the first-first connection pipes 311a, respectively. The first source gas supply pipes 321 may be respectively connected to the first-first connection pipes 311a outside the chamber 100. A first-first supply valve 431 that can be opened and closed may be installed in each of the first source gas supply pipes 321. In an embodiment, each of the first source gas supply pipes 321 may be connected to the first-first connection pipe 311a between the first common valve 410 and the first-first nozzle unit NU1a.

The second source gas supply pipes 322 may connect the second source gas supply portion 212 and the first-second connection pipes 311b, respectively. The second source gas supply pipes 322 may be respectively connected to the first-second connection pipes 311b outside the chamber 100. A first-second supply valve 432 that can be opened and closed may be installed in each of the second source gas supply pipes 322. In an embodiment, each of the second source gas supply pipes 322 may be connected to the first-second connection pipe 311b between the first common valve 410 and the first-second nozzle unit NU1b.

The third source gas supply pipes 323 may connect the third source gas supply portion 213 and the first-third connection pipes 311c, respectively. The third source gas supply pipes 323 may be respectively connected to the first-third connection pipes 311c outside the chamber 100. A first-third supply valve 433 that can be opened and closed may be installed in each of the third source gas supply pipes 323. In an embodiment, each of the third source gas supply pipes 323 may be connected to the first-third connection pipes 311c between the first common valve 410 and the first-third nozzle unit NU1c.

The configuration of the reaction gas supply portion 220, the cleaning gas supply portion 230, the remote plasma generator 240, the common pipe 340, the first exhaust pump 510, and the second exhaust pump 520 may be substantially the same as or similar to those described with reference to FIG. 7.

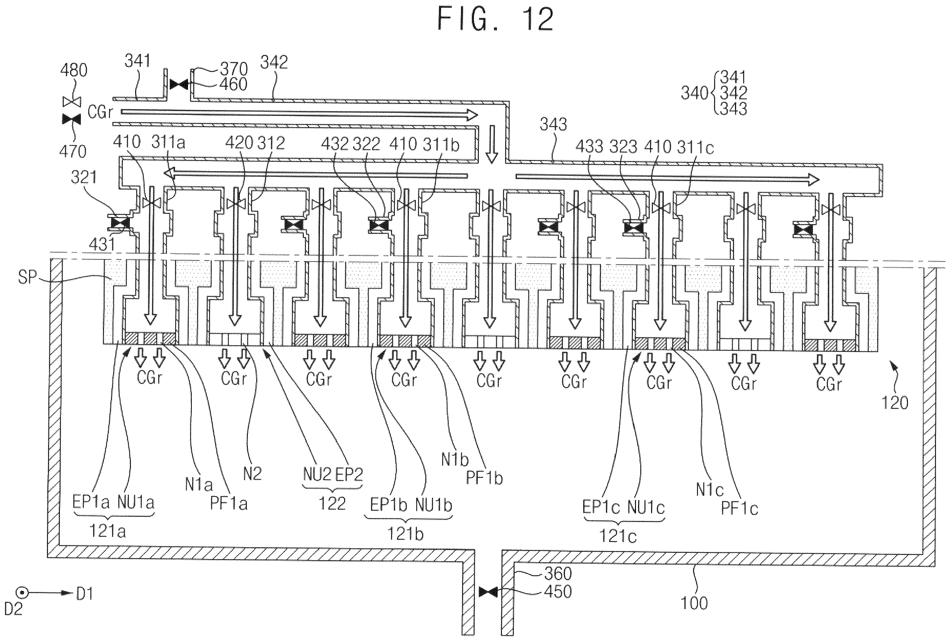

FIG. 11 and 12 are cross-sectional views for explaining an operation of the substrate processing apparatus of FIG. 10. For example, FIG. 11 may correspond to FIG. 8, and FIG. 12 may correspond to FIG. 9. For example, FIG. 11 shows a thin film deposition process on the substrate S, and FIG. 12 shows a cleaning process inside the chamber 100.

Referring to FIGS. 10 and 11, the first-first supply valves 431 installed in the first source gas supply pipes 321 may be opened. Accordingly, the first source gas SG1 may be introduced from the first source gas supply portion 211 to the first-first nozzle units NU1a through the first source gas supply pipes 321 and the first-first connection pipes 311a. The first-first nozzle units NU1a may discharge the first source gas SG1. For example, the first source gas SG1 discharged from the first-first nozzles N1a may be converted into a plasma state by the first-first plasma generator PF1a.

The first-second supply valves 432 installed in the second source gas supply pipes 322 may be opened. Accordingly, the second source gas SG2 may be introduced from the second source gas supply portion 212 to the first-second nozzle units NUlb through the second source gas supply pipes 322 and the first-second connection pipes 311b. The first-second nozzle units NUlb may discharge the second source gas SG2. For example, the second source gas SG2 discharged from the first-second nozzles N1b may be converted into a plasma state by the first-second plasma generator PF1b.

The first-third supply valves 433 installed in the third source gas supply pipes 323 may be opened. Accordingly, the third source gas SG3 may be introduced from the third source gas supply portion 213 to the first-third nozzle units NU1c through the third source gas supply pipes 323 and the first-third connection pipes 311c. The first-third nozzle units NU1c may discharge the third source gas SG3. For example, the third source gas SG3 discharged from the first-third nozzles N1c may be converted into a plasma state by the first-third plasma generator PF1c.

At this time, the first common valves 410 installed in the first-first connection pipes 311a, the first-second connection pipes 311b, and the first-third connection pipes 311c may be in a closed state. Accordingly, the reaction gas RGr in a plasma state from the common pipe 340 may not flow into the first-first connection pipes 311a, the first-second connection pipes 311b, and the first-third connection pipes 311c.

In addition, a second supply valve 470 installed in a reaction gas supply pipe 330 may be opened, and a third supply valve 480 installed in a cleaning gas supply pipe 350 may be closed. Accordingly, the reaction gas RG may be introduced into the remote plasma generator 240 from the reaction gas supply portion 220.

In addition, the second common valves 420 installed in the second connection pipes 312 may be opened. Accordingly, the reaction gas RGr converted into a plasma state in the remote plasma generator 240 may be introduced into the second nozzle units NU2 through the common pipe 340 and the second connection pipes 312. The second nozzle units NU2 may discharge the reaction gas RGr in a plasma state.

The first source gas SG1r discharged from the first-first nozzles N1a and converted into a plasma state and the reaction gas RGr in a plasma state discharged from the second nozzles N2 may react to form a first thin film on the substrate S. In addition, the second source gas SG2r discharged from the first-second nozzles N1b and converted into a plasma state and the reaction gas RGr in a plasma state discharged from the second nozzles N2 may react to from a second thin film on the substrate S. In addition, the third source gas SG3r discharged from the first-third nozzles N1c and converted to a plasma state and the reaction gas RGr in a plasma state discharged from the second nozzles N2 may react to from a third thin film on the substrate S. For example, as the substrate support portion 110 moves in the first direction D1, the first, second, and third thin films may be sequentially formed on the substrate S.

Referring to FIGS. 10 and 12, in order to clean the inside of the chamber 100 after the thin film is deposited on the substrate S, the first-first supply valves 431 installed in the first source gas supply pipes 321, the first-second supply valves 432 installed in the second source gas supply pipes 322, and the first-third supply valves 433 installed in the third source gas supply pipes 323 may be closed. Accordingly, the first, second, and third source gases SG1, SG2, and SG3 from the first, second, and third source gas supply portions 211, 212 and 213 may not flow into the first-first, first-second, and first-third connection pipes 311a, 311b, and 311c.

In addition, the second supply valve 470 installed in the reaction gas supply pipe 330 may be closed, and the third supply valve 480 installed in the cleaning gas supply pipe 350 may be opened. Accordingly, the cleaning gas CG may be introduced into the remote plasma generator 240 from the cleaning gas supply portion 230.

In addition, the first common valves 410 installed in the first-first connection pipes 311a, the first-second connection pipes 311b, and the first-third connection pipes 311c, and the second common valves 420 installed in the second connection pipes 312 may be opened. Accordingly, the cleaning gas CGr converted into a plasma state in the remote plasma generator 240 may be introduced into the first-first nozzle unit NU1a, the first-second nozzle units NU1b, the first-third nozzle units NU1c, and the second nozzle units NU2 through the common pipe 340 and the connection pipes 310. The first-first nozzles N1a, the first-second nozzles N1b, the first-third nozzles N1c, and the second nozzles N2 may discharge the cleaning gas CGr in a plasma state.

A radical of the cleaning gas CGr in a plasma state emitted from the first-first nozzles N1a, the first-second nozzles N1b, the first-third nozzles N1c, and the second nozzles N2 reacts with by-product inside the chamber 100 to convert the by-product in a gaseous state, and as the by-product in a gaseous state is exhausted, cleaning of the inside of the chamber 100 may proceed.

An exhaust process after the cleaning of the inside of the chamber 100 is performed may be substantially the same as or similar to that described with reference to FIGS. 1 and 6.

The present invention can be applied to various substrate processing apparatuses. For example, the present invention is applicable to a manufacturing apparatus of various display devices, such as display devices for vehicles, ships and aircraft, portable communication devices, display devices for exhibition or information transmission, medical display devices, or the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the present invention. Accordingly, all such modifications are intended to be included within the scope of the present invention as defined in the claims. Therefore, it is to be understood that the foregoing is illustrative of various embodiments and is not to be construed as limited to the specific embodiments disclosed, and that modifications to the disclosed embodiments, as well as other embodiments, are intended to be included within the scope of the appended claims.

## Claims

1. A substrate processing apparatus (10) comprising:
a chamber (100) providing a space for processing a substrate (S);
a first nozzle unit (NU1) disposed inside the chamber (100);
a second nozzle unit (NU2) disposed inside the chamber (100) and adjacent to the first nozzle unit (NU1);
a remote plasma generator (240) disposed outside the chamber (100) and which is configured to convert a cleaning gas (CG) into a plasma state;
a common pipe (340) disposed outside the chamber (100) and connected to the remote plasma generator (240) through which the cleaning gas in the plasma state (CGr) is able to flow from the remote plasma generator (240);
a first connection pipe (311) connecting the common pipe (340) and the first nozzle unit (NU1), and in which a first common valve (410) is installed;
a second connection pipe (312) connecting the common pipe (340) and the second nozzle unit (NU2), and in which a second common valve (420) is installed;
a source gas supply pipe (320) connected to the first connection pipe (311) in an outside of the chamber (100), and which is configured to supply a source gas (SG) to the first connection pipe (311), wherein a first supply valve (430) is installed in the source gas supply pipe (320); and
a reaction gas supply pipe (330) connected to the second connecting pipe (312) in the outside of the chamber (100), and which is configured to supply a reaction gas (RG) to the second connection pipe (312), wherein a second supply valve (440) is installed in the reaction gas supply pipe (330).

2. The substrate processing apparatus (10) of claim 1, wherein the source gas supply pipe (320) is connected to the first connection pipe (311) between the first common valve (410) and the first nozzle unit (NU1), and
wherein the reaction gas supply pipe (330) is connected to the second connection pipe (312) between the second common valve (420) and the second nozzle unit (NU2).

3. The substrate processing apparatus (10) of claim 1 or claim 2, wherein the first nozzle unit (NU1) is configured to discharge the source gas (SG) or the cleaning gas in the plasma state (CGr), and the second nozzle unit (NU2) is configured to discharge the reaction gas (RG) or the cleaning gas in the plasma state (CGr).

4. The substrate processing apparatus (10) of any one of claims 1 to 3, further comprising:
a first exhaust pump (510) connected to the chamber (100) and which is configured to exhaust a gas inside the chamber (100); and
a second exhaust pump (520) connected to the common pipe (340) and which is configured to exhaust a gas inside the common pipe (340).

5. The substrate processing apparatus (10) of claim 4, further comprising:
a first exhaust pipe (360) connecting the chamber (100) and the first exhaust pump (510), and in which a first exhaust valve (450) is installed, and
a second exhaust pipe (370) connecting the common pipe (340) and the second exhaust pump (520), and in which a second exhaust valve (460) is installed.

6. The substrate processing apparatus (10) of any one of claims 1 to 5, wherein each of the first nozzle unit (NU1) and the second nozzle unit (NU2) includes a plasma generator (PF1, PF2).

7. The substrate processing apparatus (10) of any one of claims 1 to 6, wherein each of the first nozzle unit (NU1) and the second nozzle unit (NU2) is provided in plurality, and the plurality of first nozzles (N1) and the plurality of second nozzles (N2) are alternately arranged in one direction (D1).

8. A substrate processing apparatus (11, 12) comprising:
a chamber (100) providing a space for processing a substrate (S);
a first nozzle unit (NU1) disposed inside the chamber (100);
a second nozzle unit (NU2) disposed inside the chamber (100) and adjacent to the first nozzle unit (NU1);
a remote plasma generator (240) disposed outside the chamber (100) and which is configured to convert a reaction gas (RG) or a cleaning gas (CG) into a plasma state;
a common pipe (340) disposed outside the chamber (100) and connected to the remote plasma generator (240) through which the reaction gas in a plasma state (RGr) or the cleaning gas in a plasma state (CGr) is able to flow from the remote plasma generator (240);
a first connection pipe (311, 311a) connecting the common pipe (340) and the first nozzle unit (NU1), and in which a first common valve (410) is installed;
a second connection pipe (312) connecting the common pipe (340) and the second nozzle unit (NU2), and in which a second common valve (420) is installed; and
a first source gas supply pipe (320, 321) connected to the first connection pipe (311, 311a) in an outside of the chamber (100), and which is configured to supply a first source gas (SG, SG1) to the first connection pipe (311, 311a), wherein a first-first supply valve (430, 431) is installed in the first source gas supply pipe (320, 321).

9. The substrate processing apparatus (11, 12) of claim 8, wherein the first source gas supply pipe (320, 321) is connected to the first connection pipe (311, 311a) between the first common valve (410) and the first nozzle unit (NU1).

10. The substrate processing apparatus (11, 12) of claim 8 or claim 9, wherein the first nozzle unit (NU1) is configured to discharge the first source gas (SG, SG1) or the cleaning gas in the plasma state (CGr) to the substrate (S), and the second nozzle unit (NU2) is configured to discharge the reaction gas in the plasma state (RGr) or the cleaning gas in the plasma state (CGr) to the substrate (S).

11. The substrate processing apparatus (11, 12) of claim 10, further comprising:
a reaction gas supply pipe (330) connected to the remote plasma generator (240), and which is configured to supply the reaction gas (RG) to the remote plasma generator (240), wherein a second supply valve (470) is installed in the reaction gas supply pipe (330); and
a cleaning gas supply pipe (350) connected to the remote plasma generator (240), and which is configured to supply the cleaning gas (CG) to the remote plasma generator (240), wherein a third supply valve (480) is installed in the cleaning gas supply pipe (350).

## Patentansprüche

1. Substratverarbeitungsgerät (10), Folgendes umfassend:
eine Kammer (100), die einen Raum zum Verarbeiten eines Substrats (S) bereitstellt;
eine erste Düseneinheit (NU1), die innerhalb der Kammer (100) angeordnet ist;
eine zweite Düseneinheit (NU2), die innerhalb der Kammer (100) und angrenzend an die erste Düseneinheit (NU1) angeordnet ist;
einen entfernten Plasmagenerator (240), der außerhalb der Kammer (100) angeordnet ist und der konfiguriert ist, um ein Reinigungsgas (CG) in einen Plasmazustand umzuwandeln;
ein gemeinsames Rohr (340), das außerhalb der Kammer (100) angeordnet ist und mit dem entfernten Plasmagenerator (240) verbunden ist, durch welches das Reinigungsgas im Plasmazustand (CGr) in der Lage ist, von dem entfernten Plasmagenerator (240) aus zu strömen;
ein erstes Verbindungsrohr (311), welches das gemeinsame Rohr (340) und die erste Düseneinheit (NU1) verbindet, und in dem ein erstes gemeinsames Ventil (410) installiert ist;
ein zweites Verbindungsrohr (312), welches das gemeinsame Rohr (340) und die zweite Düseneinheit (NU2) verbindet, wobei ein zweites gemeinsames Ventil (420) installiert ist;
ein Quellengas-Versorgungsrohr (320), das mit dem ersten Verbindungsrohr (311) außerhalb der Kammer (100) verbunden ist und das konfiguriert ist, um das erste Verbindungsrohr (311) mit einem Quellengas (SG) zu versorgen, wobei ein erstes Versorgungsventil (430) in dem Quellengas-Versorgungsrohr (320) installiert ist; und
ein Reaktionsgas-Versorgungsrohr (330), das mit dem zweiten Verbindungsrohr (312) außerhalb der Kammer (100) verbunden ist und das konfiguriert ist, um das zweite Verbindungsrohr (312) mit einem Reaktionsgas (RG) zu versorgen, wobei ein zweites Versorgungsventil (440) in dem Reaktionsgas-Versorgungsrohr (330) installiert ist.

2. Substratverarbeitungsgerät (10) nach Anspruch 1, wobei das Quellengas-Versorgungsrohr (320) mit dem ersten Verbindungsrohr (311) zwischen dem ersten gemeinsamen Ventil (410) und der ersten Düseneinheit (NU1) verbunden ist, und
wobei das Reaktionsgas-Versorgungsrohr (330) mit dem zweiten Verbindungsrohr (312) zwischen dem zweiten gemeinsamen Ventil (420) und der zweiten Düseneinheit (NU2) verbunden ist.

3. Substratverarbeitungsgerät (10) nach Anspruch 1 oder Anspruch 2, wobei die erste Düseneinheit (NU1) konfiguriert ist, um das Quellengas (SG) oder das Reinigungsgas im Plasmazustand (CGr) abzugeben, und die zweite Düseneinheit (NU2) konfiguriert ist, um das Reaktionsgas (RG) oder das Reinigungsgas im Plasmazustand (CGr) abzugeben.

4. Substratverarbeitungsgerät (10) nach einem der Ansprüche 1 bis 3, ferner Folgendes umfassend:
eine erste Abgaspumpe (510), die mit der Kammer (100) verbunden ist und die konfiguriert ist, um ein Gas innerhalb der Kammer (100) abzusaugen;
eine zweite Abgaspumpe (520), die mit dem gemeinsamen Rohr (340) verbunden ist und die konfiguriert ist, um ein Gas innerhalb des gemeinsamen Rohrs (340) abzusaugen.

5. Substratverarbeitungsgerät (10) nach Anspruch 4, ferner Folgendes umfassend:
ein erstes Abgasrohr (360), das die Kammer (100) und die erste Abgaspumpe (510) verbindet und in dem ein erstes Abgasventil (450) installiert ist, und
ein zweites Abgasrohr (370), welches das gemeinsame Rohr (340) und die zweite Abgaspumpe (520) verbindet und in dem ein zweites Abgasventil (460) installiert ist.

6. Substratverarbeitungsgerät (10) nach einem der Ansprüche 1 bis 5, wobei jede der ersten Düseneinheit (NU1) und der zweiten Düseneinheit (NU2) einen Plasmagenerator (PF1, PF2) einschließt.

7. Substratverarbeitungsgerät (10) nach einem der Ansprüche 1 bis 6, wobei jeweils die erste Düseneinheit (NU1) und die zweite Düseneinheit (NU2) in einer Vielzahl bereitgestellt sind und die Vielzahl erster Düsen (N1) und die Vielzahl zweiter Düsen (N2) abwechselnd in einer Richtung (D1) angeordnet sind.

8. Substratverarbeitungsgerät (11, 12), Folgendes umfassend:
eine Kammer (100), die einen Raum zum Verarbeiten eines Substrats (S) bereitstellt;
eine erste Düseneinheit (NU1), die innerhalb der Kammer (100) angeordnet ist;
eine zweite Düseneinheit (NU2), die innerhalb der Kammer (100) und angrenzend an die erste Düseneinheit (NU1) angeordnet ist;
einen entfernten Plasmagenerator (240), der außerhalb der Kammer (100) angeordnet ist und der konfiguriert ist, um ein Reaktionsgas (RG) oder ein Reinigungsgas (CG) in einen Plasmazustand umzuwandeln;
ein gemeinsames Rohr (340), das außerhalb der Kammer (100) angeordnet ist und mit dem entfernten Plasmagenerator (240) verbunden ist, durch welches das Reaktionsgas in einem Plasmazustand (RGr) oder das Reinigungsgas in einem Plasmazustand (CGr) in der Lage ist, von dem entfernten Plasmagenerator (240) aus zu strömen;
ein erstes Verbindungsrohr (311, 311a), welches das gemeinsame Rohr (340) und die erste Düseneinheit (NU1) verbindet, und in dem ein erstes gemeinsames Ventil (410) installiert ist;
ein zweites Verbindungsrohr (312), welches das gemeinsame Rohr (340) und die zweite Düseneinheit (NU2) verbindet, und in dem ein zweites gemeinsames Ventil (420) installiert ist; und
ein erstes Quellengas-Versorgungsrohr (320, 321), das mit dem ersten Verbindungsrohr (311, 311a) außerhalb der Kammer (100) verbunden ist, und das zum Versorgen des ersten Verbindungsrohrs (311, 311a) mit einem ersten Quellengas (SG, SG1) konfiguriert ist, wobei ein erstes Versorgungsventil (430, 431) in dem ersten Quellengas-Versorgungsrohr (320, 321) installiert ist.

9. Substratverarbeitungsgerät (11, 12) nach Anspruch 8, wobei das erste Quellengas-Versorgungsrohr (320, 321) mit dem ersten Verbindungsrohr (311, 311a) zwischen dem ersten gemeinsamen Ventil (410) und der ersten Düseneinheit (NU1) verbunden ist.

10. Substratverarbeitungsgerät (11, 12) nach Anspruch 8 oder Anspruch 9, wobei die erste Düseneinheit (NU1) konfiguriert ist, um das erste Quellengas (SG, SG1) oder das Reinigungsgas im Plasmazustand (CGr) an das Substrat (S) abzugeben, und die zweite Düseneinheit (NU2) konfiguriert ist, um das Reaktionsgas im Plasmazustand (RGr) oder das Reinigungsgas im Plasmazustand (CGr) an das Substrat (S) abzugeben.

11. Substratverarbeitungsgerät (11, 12) nach Anspruch 10, ferner Folgendes umfassend:
ein Reaktionsgas-Versorgungsrohr (330), das mit dem entfernten Plasmagenerator (240) verbunden ist und das konfiguriert ist, um den entfernten Plasmagenerator (240) mit dem Reaktionsgas (RG) zu versorgen, wobei ein zweites Versorgungsventil (470) in dem Reaktionsgas-Versorgungsrohr (330) installiert ist; und
ein Reinigungsgas-Versorgungsrohr (350), das mit dem entfernten Plasmagenerator (240) verbunden ist und das konfiguriert ist, um den entfernten Plasmagenerator (240) mit dem Reinigungsgas (CG) zu versorgen, wobei ein drittes Versorgungsventil (480) in dem Reinigungsgas-Versorgungsrohr (350) installiert ist.

## Revendications

1. Appareil de traitement de substrat (10) comprenant :
une chambre (100) fournissant un espace destiné au traitement d'un substrat (S) ;
une première unité formant buse (NU1) disposée à l'intérieur de la chambre (100) ;
une deuxième unité formant buse (NU2) disposée à l'intérieur de la chambre (100) et adjacente à la première unité formant buse (NU1) ;
un générateur de plasma distant (240) disposé à l'extérieur de la chambre (100) et qui est configuré pour convertir un gaz d'épuration (CG) en un état de plasma ;
un tuyau commun (340) disposé à l'extérieur de la chambre (100) et raccordé au générateur de plasma distant (240) à travers lequel le gaz d'épuration à l'état de plasma (CGr) est apte à s'écouler à partir du générateur de plasma distant (240) ;
un premier tuyau de raccordement (311) raccordant le tuyau commun (340) et la première unité formant buse (NU1), et dans lequel une première vanne commune (410) est installée ;
un deuxième tuyau de raccordement (312) raccordant le tuyau commun (340) et la deuxième unité formant buse (NU2), et dans lequel une deuxième vanne commune (420) est installée ;
un tuyau d'alimentation en gaz source (320) raccordé au premier tuyau de raccordement (311) dans un extérieur de la chambre (100), et qui est configuré pour alimenter en gaz source (SG) le premier tuyau de raccordement (311), dans lequel une première vanne d'alimentation (430) est installée dans le tuyau d'alimentation en gaz source (320) ; et
un tuyau d'alimentation en gaz de réaction (330) raccordé au deuxième tuyau de raccordement (312) à l'extérieur de la chambre (100), et qui est configuré pour alimenter en gaz de réaction (RG) le deuxième tuyau de raccordement (312), dans lequel une deuxième vanne d'alimentation (440) est installée dans le tuyau d'alimentation en gaz de réaction (330).

2. Appareil de traitement de substrat (10) selon la revendication 1, dans lequel le tuyau d'alimentation en gaz source (320) est raccordé au premier tuyau de raccordement (311) entre la première vanne commune (410) et la première unité formant buse (NU1), et
dans lequel le tuyau d'alimentation en gaz de réaction (330) est raccordé au deuxième tuyau de raccordement (312) entre la deuxième vanne commune (420) et la deuxième unité formant buse (NU2).

3. Appareil de traitement de substrat (10) selon la revendication 1 ou la revendication 2, dans lequel la première unité formant buse (NU1) est configurée pour décharger le gaz source (SG) ou le gaz d'épuration à l'état de plasma (CGr), et la deuxième unité formant buse (NU2) est configurée pour décharger le gaz de réaction (RG) ou le gaz d'épuration à l'état de plasma (CGr).

4. Appareil de traitement de substrat (10) selon l'une quelconque des revendications 1 à 3, comprenant en outre :
une première pompe d'évacuation (510) raccordée à la chambre (100) et qui est configurée pour évacuer un gaz à l'intérieur de la chambre (100) ; et
une deuxième pompe d'évacuation (520) raccordée au tuyau commun (340) et qui est configurée pour évacuer un gaz à l'intérieur du tuyau commun (340).

5. Appareil de traitement de substrat (10) selon la revendication 4, comprenant en outre :
un premier tuyau d'évacuation (360) raccordant la chambre (100) et la première pompe d'évacuation (510), et dans laquelle une première vanne d'évacuation (450) est installée, et
un deuxième tuyau d'évacuation (370) raccordant le tuyau commun (340) et la deuxième pompe d'évacuation (520), et dans lequel une deuxième vanne d'évacuation (460) est installée.

6. Appareil de traitement de substrat (10) selon l'une quelconque des revendications 1 à 5, dans lequel chacune de la première unité formant buse (NU1) et de la deuxième unité formant buse (NU2) inclut un générateur de plasma (PF1, PF2).

7. Appareil de traitement de substrat (10) selon l'une quelconque des revendications 1 à 6, dans lequel chacune de la première unité formant buse (NU1) et de la deuxième unité formant buse (NU2) est fournie en une pluralité, et la pluralité de premières buses (N1) et la pluralité de deuxièmes buses (N2) sont disposées en alternance dans une direction (D1).

8. Appareil de traitement de substrat (11, 12) comprenant :
une chambre (100) fournissant un espace destiné à traiter un substrat (S) ;
une première unité formant buse (NU1) disposée à l'intérieur de la chambre (100) ;
une deuxième unité formant buse (NU2) disposée à l'intérieur de la chambre (100) et adjacente à la première unité formant buse (NU1) ;
un générateur de plasma distant (240) disposé à l'extérieur de la chambre (100) et qui est configuré pour convertir un gaz de réaction (RG) ou un gaz d'épuration (CG) dans un état de plasma ;
un tuyau commun (340) disposé à l'extérieur de la chambre (100) et raccordé au générateur de plasma distant (240) à travers lequel le gaz de réaction dans un état de plasma (RGr) ou le gaz d'épuration dans un état de plasma (CGr) est apte à s'écouler à partir du générateur de plasma distant (240) ;
un premier tuyau de raccordement (311, 311a) raccordant le tuyau commun (340) et la première unité formant buse (NU1), et dans lequel une première vanne commune (410) est installée ;
un deuxième tuyau de raccordement (312) raccordant le tuyau commun (340) et la deuxième unité formant buse (NU2), et dans lequel une deuxième vanne commune (420) est installée ; et
un premier tuyau d'alimentation en gaz source (320, 321) raccordé au premier tuyau de raccordement (311, 311a) dans un extérieur de la chambre (100), et qui est configuré pour alimenter en un premier gaz source (SG, SG1) le premier tuyau de raccordement (311, 311a), dans lequel une première vanne d'alimentation (430, 431) est installée dans le premier tuyau d'alimentation en gaz source (320, 321).

9. Appareil de traitement de substrat (11, 12) selon la revendication 8, dans lequel le premier tuyau d'alimentation en gaz source (320, 321) est raccordé au premier tuyau de raccordement (311, 311a) entre la première vanne commune (410) et la première unité formant buse (NU1).

10. Appareil de traitement de substrat (11, 12) selon la revendication 8 ou la revendication 9, dans lequel la première unité formant buse (NU1) est configurée pour décharger le premier gaz source (SG, SG1) ou le gaz d'épuration à l'état de plasma (CGr) vers le substrat (S), et la deuxième unité formant buse (NU2) est configurée pour décharger le gaz de réaction à l'état de plasma (RGr) ou le gaz d'épuration à l'état de plasma (CGr) vers le substrat (S).

11. Appareil de traitement de substrat (11, 12) selon la revendication 10, comprenant en outre :
un tuyau d'alimentation en gaz de réaction (330) raccordé au générateur de plasma distant (240), et qui est configuré pour alimenter en gaz de réaction (RG) le générateur de plasma distant (240), dans lequel une deuxième vanne d'alimentation (470) est installée dans le tuyau d'alimentation en gaz de réaction (330) ; et
un tuyau d'alimentation en gaz d'épuration (350) raccordé au générateur de plasma distant (240), et qui est configuré pour alimenter en gaz d'épuration (CG) le générateur de plasma distant (240), dans lequel une troisième vanne d'alimentation (480) est installée dans le tuyau d'alimentation en gaz d'épuration (350).
